**Europäisches Patentamt**

(19) **European Patent Office**

**Office européen des brevets**

(11) Publication number: **0 145 162**
**A2**

(12) **EUROPEAN PATENT APPLICATION**

(21) Application number: **84306927.9**

(22) Date of filing: **10.10.84**

(51) Int. Cl.⁴: **G 11 C 11/40**
**G 11 C 7/00**

(30) Priority: **10.11.83 US 551734**

(43) Date of publication of application:
**19.06.85 Bulletin 85/25**

(84) Designated Contracting States:
**DE FR GB NL**

(71) Applicant: **Monolithic Memories, Inc.**
**2175 Mission College Blvd.**
**Santa Clara, CA 95050(US)**

(72) Inventor: **Hoberman, Barry A.**
**777 San Antonio Road**
**Palo Alto California 94303(US)**

(72) Inventor: **Moss, William E.**
**510 Humber Court**
**Sunnyvale California 94087(US)**

(74) Representative: **Jones, Ian et al,**
**POLLAK MERCER & TENCH High Holborn House 52-54**
**High Holborn**
**London WC1V 6RY(GB)**

(54) **Differential sense amplifier.**

(57) A novel sense amplifier (30a) as provided for receiving a small differential input signal, such as from a memory cell storing data. The differential sense amplifier provides on a pair of output leads 30-3, 30-4 a differential impedance in response to said differential input signal. In one embodiment to this invention, the differential sense amplifier includes means D79, D80, D81, D82 for being selectively enabled and, when disabled, provides a high impedance on both differential output leads.

./...

EP 0 145 162 A2

Croydon Printing Company Ltd.

FIG.2

-1-

# DIFFERENTIAL SENSE AMPLIFIER

## DESCRIPTION

This invention relates to a differential sense amplifier.

Integrated circuits and integrated circuit memories which provide low-level differential signals representing data are well known in the prior art. Such circuits typically include flip flops, first-in first-out (FIFO) memories, emitter coupled logic (ECL) devices, and the like. To assist in the disclosure of the present invention, reference is made to United States Patent 4 151 609 issued April 24 1979 to Moss. This US Patent discloses a first-in first-out memory which includes a plurality of data cells for storing an equal plurality of binary digits ("bits"). A new bistable latch suitable for serving as a memory cell is disclosed in European Patent Application                , which claims priority from US Patent Application Serial Number 06/551 736 filed on 10 November 1983 by Hoberman and Moss and entitled "Memory Cell and Array".

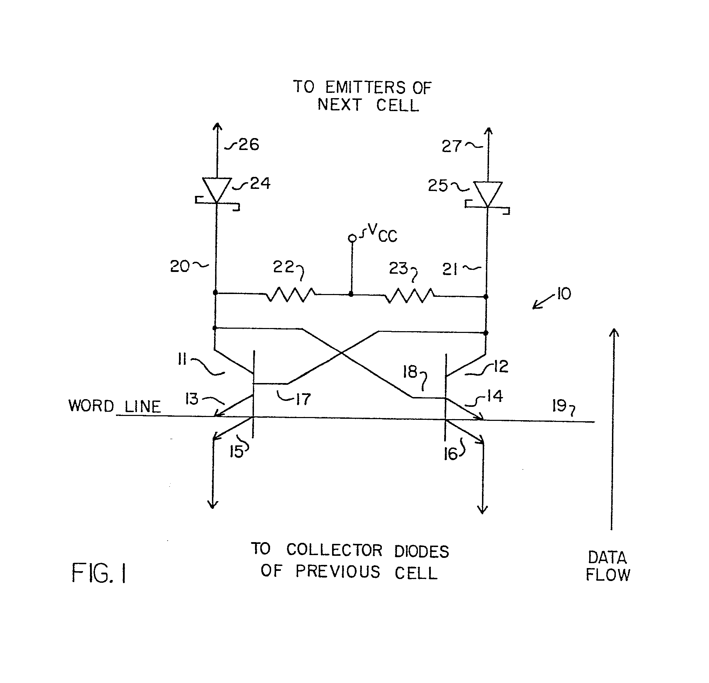

While it will be appreciated by those of ordinary skill in the art that a large number of such bistable latches are in existence or can be devised for the purpose of storing digital information, reference will now be made by way of example to the bistable latch or diagrammatically shown in Figure 1 of the drawings accompanying the present specification.

-2-

The illustrated bistable latch 10 includes dual-emitter NPN transistors 11 and 12, with emitter 13 of transistor 11 and emitter 14 of transistor 12 connected in common to word line 19. Word line 19 serves as a control line to the cell and, when high (logical 1, typically 2.5 volts) cell 10 is in the "receive and store" mode of operation and can receive data from the previous cell and store that data until additional data is to be received from the previous cell. Conversely, when word line 19 is low (logical 0, typically 0.6 volts), cell 10 provides its data to the next cell, and this data is copied into the next cell and stored.

Base 17 of transistor 11 is connected to the collector 21 of transistor 12 and likewise base 18 of transistor 12 is connected to collector 20 of transister 11. Of importance, transistors 11 and 12 can, if desired, comprise Schottky transistors which provide a faster switching speed and therefore a faster memory device. The collectors 20, 21 of transistors 11, 12 are connected to a positive supply voltage Vcc via resistors 22, 23, respectively. Collectors 20, 21 are connected to the emitters of the next cell (not shown) via leads 26, 27 through Schottky diodes 24, 25, respectively. Emitters 15, 16 of transistors 11, 12 are connected to the collectors of the cross-coupled transistors of the previous cell (not shown) via Schottky diodes contained within the previous cell.

To receive data in cell 10 from the previous cell, word line 19 is held high and the word line of the previous cell (not shown) is brought low. In order to store this data in cell 10, word line 19 is held high, and the word line of the previous word is held high, thereby not transferring new data to cell 10. In order for cell 10 to write its data into the next cell (not shown), word line 19 goes low.

To read the data stored within cell 10 (assuming cell 10 is the lowermost cell of a FIFO memory, or is a discrete cell), the voltages on leads 26 and 27 are examined. If the differential voltage between leads 26 and 27 is positive (ie lead 27 is positive with respect to lead 26), a logical 1 is stored; conversely, if the differential voltage between leads 26 and 27 is negative (ie lead 27 is negative with respect to lead 26), a logical zero is stored. Typically, this differential voltage between leads 26 and 27 will be on the order of ±450 millivolts at room temperature and as little as ±200 millivolts at elevated temperatures (such as when the integrated circuit device operates in an ambient temperature of apprxomately 125°C). Oftentimes these rather minute differential voltages are not suitable for direct use by other circuitry such as the widely-used transistor-transistor logic (TTL) devices. Accordingly, it is necessary to perform a voltage translation of this differential voltage to a level which is suitable for direct use by external circuitry such as TTL devices.

US Patent 4 151 609 describes an output buffer latch 71 which is suitable for translating the differential output voltage from a bistable latch to a level suitable for use by TTL devices. The output buffer latch 71 in serving as a latch thereby temporarily stores data.

Since this disclosure, this type of output buffer latch has been used by others to convert a low-voltage differential data signal to a signal suitable for use by other circuitry. However, these types of prior art sense amplifiers oftentimes suffer from the disadvantage that the very small differential voltages received to be sensed require that extremely tight tolerances be maintained on the components forming the sense amplifier. Not only is this a burden for the design engineer, but oftentimes when fabricating semiconductor devices, precise resistor values, doping levels, threshold voltages, etc. cannot be obtained, or are obtained only at the expense of very careful, and thus very costly, fabricating procedures. Even with such careful attention to detail during fabrication, oftentimes the tight tolerances are not met, with a resulting low yield, thereby increasing the cost of manufacturing such devices.

The present invention accordingly provides a differential sense amplifier having input means for receiving a small differential voltage signal, characterized by output means for providing a differential impedance output signal.

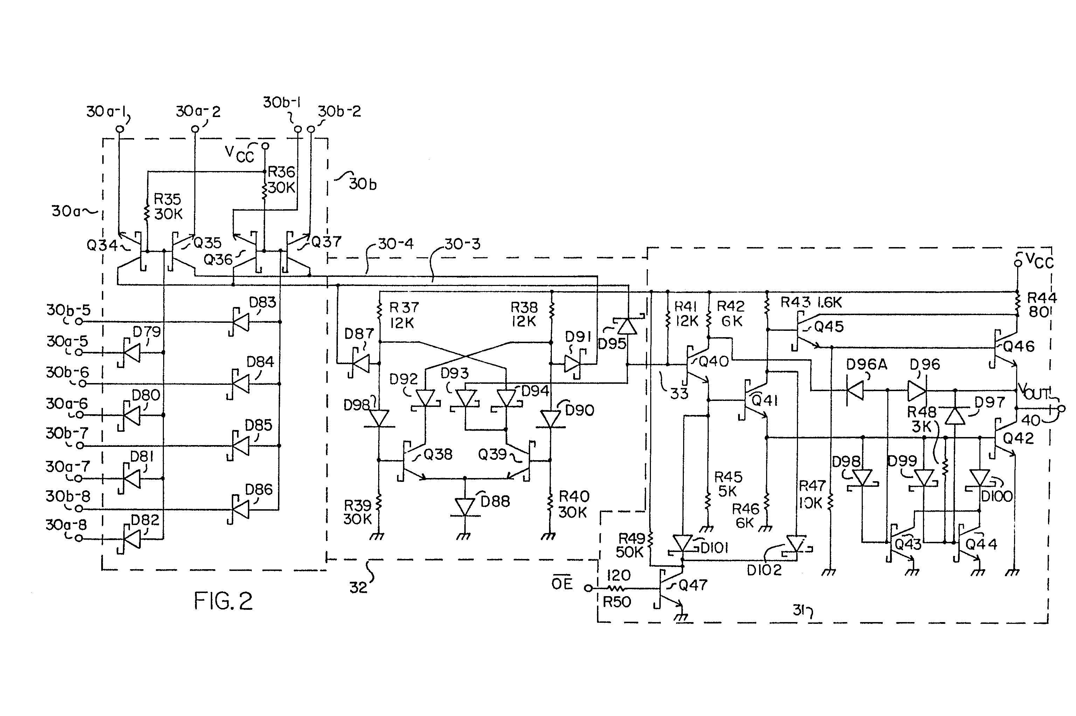

The invention will be more fully understood from the following illustrative description and from Figure 2 of the accompanying drawings, which is a schematic diagram depicting two differential sense amplifiers in accordance with this present invention, together with associated circuitry which can, if desired, be used with one or more such sense amplifiers.

Referring to Figure 2, sense amplifiers 30a and 30b constructed in accordance with this invention are shown. Sense amplifier 30a includes NPN Schottky transistors Q34, 35, having their bases connected in common through resistor R35 (typically 30K ohms) to a positive voltage supply Vcc (typically 5 volts). The emitter of transistor Q34 and the emitter of transistor Q35 receive via leads 30a-1 and 30a-2, respectively, the differential signal voltage from a memory cell, such as the memory cell depicted in Figure 1. The collectors of transistors Q34 and Q35 are connected to output leads 30-3 and 30-4, respectively, and supply on these output leads a differential impedance to additional circuitry such as output buffer 31, and output data latch 32. For the purposes of this specification, output buffer 31 is shown which receives a signal on lead 30-3 and, in response to this signal, provides an output voltage Vout on output terminal 40 which is suitable for use with TTL circuitry. Naturally, it is understood that output buffer 31 need not be used, and the signal voltages on leads 30-3 and 30-4 may be used either singularly or in combination to provide a signal to any one of a number of other circuits. For example, the differential signal impedances on the leads 30-3 and 30-4 are also shown connected to data output latch 32, which in this instance ensures a proper signal is provided to output buffer 31 during the transition of data states received on input signal lead pairs 30a-1, 30a-2 and 30b-1, 30b-2.

Referring now to differential sense amplifier 30a, it is seen that a plurality of diodes D79 through D82 are connected to the bases of transistors Q34 and Q35. Diodes D79 through D82 receive on their cathodes 30a-5 through 30a-8, respectively, control signals which selectively enable differential sense amplifier 30a. When enabled, differential sense amplifier 30a will sense the data provided as a differential signal voltage on its input leads 30a-1, 30a-2 and provide on its output leads 30-3, 30-4, a low-impedance/high-impedance differential output signal. Diodes D79 through D82 serve to combine in a logical AND operation the control signals received on terminals 30a-5 through 30a-8, respectively. Differential sense amplifier 30a will be enabled only when the control signals applied to terminals 30a-5 through 30a-8 are all logical ones. If any of the control signals applied to terminals 30a-5 through 30a-8 is a logical zero, the base of transistors Q34 and Q35 will be pulled low, thereby preventing transistors Q34, Q35 from turning on, and differential sense amplifier 30a will be disabled and provide high impedances on both output leads 30-3 and 30-4.

Differential sense amplifier 30-b functions in a similar manner to differential sense amplifier 30a, receiving differential input signals on input terminals 30b-1 and 30b-2, and providing output signals on output leads 30-3 and 30-4. Differential sense amplifier 30b is enabled when all control signals applied to terminals 30b-5 through 30b-8 are logical ones. Conversely, differential sense amplifier 30b is disabled when any of the control signals applied to terminals 30b-5 through 30b-8 is a logical zero.

Any number of differential sense amplifiers may be constructed in accordance with this invention and connected to a single pair of output leads 30-3 and 30-4 using appropriate control signals to enable only a selected one of the differential sense amplifiers at any given time. Alternatively, more than one differential sense amplifier can be enabled at any given time, thereby providing on their output leads a signal resulting from a logical operation performed on the data received by the plurality of enabled sense amplifiers. In the case where a single differential sense amplifier is enabled, the disabled differential sense amplifiers provide a high impedance to output leads 30-3 and 30-4, and the single enabled differential sense amplifier provides a high impedance to a selected one of output leads 30-3, 30-4 and a low impedance to the other output lead. Which output lead receives the low impedance from the enabled differential sense amplifier is determined by the state of the differential signal voltage received by the enabled differential sense amplifier.

For example, assume that differential sense amplifier 30-a is to be enabled and differential sense amplifier 30-b is to be disabled. In this event, any one or more of the control signals applied to control terminals 30b-5 through 30b-8 is a logical zero, thereby disabling differential sense amplifier 30b by pulling the bases of transistors Q36, Q37 low, thereby turning off transistors Q36 and Q37. With transistors Q36 and Q37 turned off, no current may flow between the collectors and the emitters of transistors Q36, Q37, and thus transistors Q36 and Q37 provide a high impedance to output leads 30-3 and 30-4, respectively. At the same time, all control signals applied to control terminals 30a-5 through 30a-8 must be logical ones, thereby keeping the bases of transistors Q34, Q35 high. With the bases of transistors Q34 and Q35 high, the differential signal data applied to terminals 30a-1 and 30a-2 determine which one of the two transistors Q34 and Q35 is turned on. For example, if the differential signal voltage applied to input terminals 30a-1 and 30a-2 is positive, signifying a logical one (i.e., input terminal 30a-2 is positive with respect to input terminal 30a-1), the base emitter junction of transistor Q34 is forward biased and transistor Q34 conducts. Similarly, the base-emitter junction of transistor Q35 is not forward biased and transistor Q35 is turned off. Thus, in response to a logical one input signal, output lead 30-3 receives a low impedance and output lead 30-4 receives a high impedance from differential sense amplifier 30a.

Conversely, with differential sense amplifier 30a enabled and a negative differential input signal received on input terminals 30a-1 and 30a-2 signifying a logical zero (i.e., terminal 30a-2 is negative with respect to terminal 30a-1), the base emitter junction of transistor Q35 is forward biased and transistor Q35 is turned on, and the base-emitter junction of transistor Q34 is not forward biased, and transistor Q34 is turned off. Thus, in response to a logical zero differential input signal on leads 30a-1 and 30a-2, sense amplifier 30a provides a high impedance to output lead 30-3 and a low impedance to output lead 30-4.

In contrast to prior art sense amplifiers used for sensing the state of a differential logic signal, the differential sense amplifier of this invention is extremely sensitive, providing a well-defined change in impedance on its output leads in response to a relatively small differential input signal voltage. The difference in impedance on output leads 30-3 and 30-4 between a logical zero state and a logical one state is many (typically 5 or more) orders of magnitude. This is in contrast to prior art differential sense amplifiers in which there is essentially no change in impedance on the output leads, but only a minor change in the differential voltage on the output leads between a logical one and a logical zero input signal being sensed. Due to this limitation of prior art circuits, most prior art circuits are extremely difficult to design and manufacture to assure that they will operate over a wide temperature range, as well as over wide power supply voltage range, and when using standard semiconductor processing techniques and tolerances.

To describe but one use for the novel differential sense amplifier of this invention, reference is now made to output buffer 31 of Figure 2. Output buffer 31 is a typical output buffer used to receive a signal voltage and provide a TTL-compatible output signal Vout on output terminal 40. The output enable signal ($\overline{OE}$) serves to selectively enable output buffer 31. Output buffer 31 receives a single-ended signal on input lead 33 from output lead 30-3 via Schottky diode D95. In response to a logical zero output signal on lead 30-3 (a high impedance), diode D95 is not forward biased. Input lead 33 is pulled high by resistor R41 connected between Vcc and lead 33, Schottky transistor Q40 turns on, thus turning on transistor Q41 which in turn turns on transistor Q42, thus pulling output terminal 40 low. Also, with transistor Q41 on, there is insufficient voltage on the collector of transistor Q41 to turn on both transistor Q45 and transistor Q46, and thus transistor Q46 remains off. Thus, Vout is a TTL low (typically 0.3 volts) in response to a logical zero (high impedance) signal on output lead 30-3 from the differential sense amplifiers 30a and 30b.

Conversely, with a logical one (low impedance) provided on output lead 30-3 by the differential sense amplifiers, Schottky diode D95 is forward biased, input lead 33 is pulled low, to a voltage level which is insufficient to allow all of transistors Q40, Q41, and Q42 to turn on, and thus transistor Q42 remains off. Similarly, with transistor Q41 only partially turned on, the collector of transistor Q41 is sufficiently high to cause both transistors Q45 and Q46 to turn on, thus providing a current path from Vcc through resistor R44 and transistor Q46 to output terminal 40. Thus, the output signal Vout is a TTL high (typically 3.0 volts).

Of interest, there is an upper limit to the common-mode voltage of the differential input signal applied to the input leads of the sense amplifier required to maintain proper operation of the sense amplifier. This limit is dependent upon both the source of the differential signal and the circuitry to which the output leads of the sense amplifier are connected. The origin of this limit is the need to maintain the operating point of the transistor (either one of transistors Q34 or Q35 for sense amplifier 30a; either one of transistors Q36 or Q37 for sense amplifier 30b) providing a low impedance to the selected one of output leads 30-3 and 30-4 in the forward saturated state. Failure to observe this common-mode limit will cause the transistor providing the low impedance to enter a state in which the base-collector junction is forward-biased and the base-emitter junction is not forward-biased, resulting in current-sourcing to the low impedance output lead, rather than the desired current-sinking from the low impedance output lead.

As but one additional example of the use of the differential sense amplifier of this invention, reference is now made to data output latch 32 of Figure 2. Consider first the example when a logical one is stored in data output latch 32. In this event, transistor Q38 will be off and transistor Q39 will be on. With transistor Q39 on, the collector of transistor Q39 is low, and the anode of diode D89 is held sufficiently low to prevent the base-emitter junction of transistor Q38 from being forward biased, thereby keeping transistor Q38 off. Conversely, when a logical zero is stored in data output latch 32, transistor Q39 is turned off and transistor Q38 is on. With transistor Q38 on, its collector is low, thus keeping the anode of diode D90 sufficiently low to prevent transistor Q39 from turning on. If all differential sense amplifiers having their leads connected to leads 30-3 and 30-4 are disabled, both output leads 30-3 and 30-4 will be high impedance, thereby preventing a change in the data stored in data output latch 32. However, in response to a logical zero on output leads 30-3 and 30-4 (i.e., output lead 30-3 is a high impedance and output lead 30-4 is a low impedance), diode D91 will be turned on, thereby pulling the anode of diode D90 low, and preventing the base-emitter junction of transistor Q39 from being forward biased, thus turning transistor Q39 off. Also, with transistor Q39 turned off and output lead 30-3 a high impedance, the anode of diode D89 will be high, thus forward bias-emitter junction of transistor Q38, and turning on transistor Q38. With transistor Q39 turned off and transistor Q38 turned on, a logical zero is stored in data output latch 32. Conversely, in response to a logical one output signal available on output leads 30-3 and 30-4 (ie output lead 30-3 is low impedance and output lead 30-4 is high impedance), diode D87 will be turned on, thus pulling the anode of diode D89 low, to a level which is insufficient to cause the base-emitter junction of transistor Q38 to be forward biased, thus turning transistor Q38 off. Also, with transistor Q38 turned off and output lead 30-4 a high impedance, the anode of diode D90 is high, thus forward biasing the base-emitter junction of transistor Q39 and turning on transistor Q39. With transistor Q39 turned on and transistor Q38 turned off, a logical one is stored in data output latch 32.

Although the present invention has been described with reference to a presently preferred embodiment, it is to be understood that the disclosure is not to be interpreted as limiting. Various alterations and modifications will be apparent to those skilled in the art after having read the above disclosure. For example, it will be apparent that MOS transistors can be used, other than the bipolar transistors depicted.

CLAIMS

1. A differential sense amplifier having input means for receiving a small differential voltage signal, characterized by output means for providing a differential impedance output signal.

2. A sense amplifier as claimed in claim 1 wherein the input means comprises a first input lead (30a-1) for receiving a first signal voltage and a second input lead (30a-2) for receiving a second signal voltage, the difference between the first signal voltage and the second voltage being said differential input voltage signal.

3. A sense amplifier as claimed in claim 2 having a first transistor (R35) having a first current handling terminal connected to the first input lead (30a-1), a second current handling terminal connected to a first output lead (30-3), and a control terminal;

a second transistor (R36) having a first current handling terminal connected to the second input lead (30a-2), a second current handling terminal connected to a second output lead (30-4) and a control terminal connected to the control terminal of the first transistor;

means for applying a first selected voltage to the control terminals of the first and second transistors, wherein the first output lead provides a high impedance and the second output lead provides a low impedance in response to a negative differential input signal in which the voltage applied to the second input lead is less than the voltage applied to the first input lead, and wherein the first output lead provides a low impedance and the second output lead provides a high impedance in response to a positive differential signal voltage in which the signal voltage applied to the first input lead is less positive than the signal voltage applied to the second input lead.

0145162

-13-

4. A sense amplifier as claimed in claim 3 wherein the transistors (Q35, Q36) are Schottky transistors.

5. A sense amplifier as claimed in claim 3 or 4 having means for applying a second selected voltage to the control terminals of the first and second transistors, thereby preventing turning on of the first and second transistors and providing a high impedance on both the irst and second output leads (30-3, 30-4).

6. A plurality of multiplexed sense amplifiers each as claimed in claim 5 for receiving an equal plurality of differential input signals, wherein the first output leads (30-3) of the plurality of differential sense amplifiers (30-a, 30-b) are connected in common and the second output leads (30-4) of the plurality of differential sense amplifiers are connected in common, and having means for enabling a selected one of the plurality of differential sense amplifiers such that the selected one amplifier provides a low impedance on a selected one of the first and second output leads in response to the differential input signal applied to the enabled differential sense amplifier, the remaining one or ones of the plurality of sense amplifiers being disabled, thereby having no effect on the output leads.

7. A plurality of multiplexed sense amplifiers as claimed in claim 5 for receiving an equal plurality of differential input signals, wherein the first output leads (30-3) of the plurality of differential sense amplifiers are connected in common and the second output leads (30-4) of the plurality of differential sense amplifiers are connected in common, and having means for enabling selected ones of the plurality of differential sense amplifiers such that the selected ones of the amplifiers provide a low impedance on a selected one or both of the first and second output leads in response to the differential input signals applied to the enabled differential sense amplifiers, the remaining one or ones

-14-

of the plurality of sense amplifiers being disabled, thereby having no effect on the output leads.

TO EMITTERS OF
NEXT CELL

FIG. 1

TO COLLECTOR DIODES
OF PREVIOUS CELL

WORD LINE

$V_{CC}$

DATA
FLOW

FIG. 2

2/2

0145162